# EUROPEAN PATENT APPLICATION

(11) **EP 4 475 399 A1**
(43) Date of publication of application: **11.12.2024**
(21) Application number: 23746962.2
(22) Date of filing: 25.01.2023
(51) Int. Cl.: H02K 3/26, H02K 3/47

(54) **COIL SUBSTRATE, COIL SUBSTRATE FOR MOTOR, AND MOTOR**

(30) Priority: 31.01.2022 JP 2022012945
(71) Applicant: IBIDEN CO., LTD., Ogaki-shi, Gifu 503-8604 (JP)
(72) Inventor: HIRASAWA, Takahisa, Ogaki-shi, Gifu 503-8503 (JP); FURUNO, Takayuki, Ogaki-shi, Gifu 503-8503 (JP)
(74) Representative: Hoefer & Partner Patentanwälte mbB
(86) International application number: PCT/JP2023/002174
(87) International publication number: WO 2023/145751

(57) **Abstract**

The present invention provides technology that enables wiring on an inner peripheral layer and wiring on an outer peripheral layer to be positioned more accurately when a coil substrate is wound into a cylindrical shape. The coil substrate comprises: a flexible substrate having a first surface and a second surface on the reverse side from the first surface; and a coil formed from coil-shaped wiring provided on the first surface and coil-shaped wiring provided on the second surface. The coil substrate can be formed into a cylindrical shape by being circumferentially wound about an axis extending in the lateral direction orthogonal to the longitudinal direction, starting from a reference side at one end in the longitudinal direction of the flexible substrate. The flexible substrate has recesses formed on at least one of the two sides thereof in the width direction.

## Description

### [Technical Field]

The technology disclosed in the present specification relates to a coil board, a motor coil board formed by using the coil board, and a motor formed by using the motor coil board.

### [Background Art]

Patent Document 1 describes a coil body formed into a cylindrical shape by winding a printed wiring board multiple times, the printed wiring board having spiral-shaped wiring patterns formed on both faces thereof. Marks for positioning a part of the printed board constituting an inner circumferential-side layer and a part constituting an outer circumferential-side layer are provided on the printed board. The centers of the wiring patterns are aligned when the printed wiring board is wound by overlaying the marks formed on the inner circumferential-side layer and the marks formed on the outer circumferential-side layer.

### [Prior Art Documents]

### [Patent Documents]

[Patent Document 1] WO 2018/193618A1

### [Summary of the Invention]

### [Problems in Patent Document 1]

In the technology of Patent Document 1, it may not be easy to check whether the marks are suitably overlaid with each other when the flexible board is wound multiple times to form the cylindrical shape. There is considered to be a need for technology that will allow more suitable positioning of the wiring on the inner circumferential-side layer and the wiring on the outer circumferential-side layer when the flexible board is wound multiple times to form the cylindrical shape.

### [Means for Solving the Problems]

A coil board according to the present invention comprises: a flexible board having a first face and a second face on the opposite side to the first face; and coils formed by coil-shaped wiring provided on the first face and coil-shaped wiring provided on the second face. The coil board is wound in a circumferential direction about an axis extending in a width direction orthogonal to a longitudinal direction of the flexible board, starting from a reference edge on one end side of the flexible board in the longitudinal direction, and can thereby be formed into a cylindrical shape. The flexible board comprises a recess formed on at least one of two edges in the width direction.

The flexible board of the coil board according to the present invention comprises the recess formed on at least one of the two edges in the width direction. The flexible board is therefore wound while using the recess as a reference, whereby the wiring on the inner circumferential-side layer and the wiring on the outer circumferential-side layer can be suitably positioned when the cylindrical shape has been formed. When a motor coil board is formed by winding the coil board according to the present invention in the circumferential direction, winding misalignment therefore does not occur, so there are no longer coils generating ineffective torque. Torque ripple is reduced. When a motor is formed by using the coil board according to the present invention, a motor having stable performance can therefore be obtained.

In the coil board according to the present invention, the recess may be used for positioning when the coil board is wound in the circumferential direction.

In the coil board according to the present invention, the flexible board may comprise a plurality of the recesses formed along the longitudinal direction on at least one of the two edges in the width direction.

In the coil board according to the present invention, the plurality of recesses may be overlaid with each other by winding the flexible board N times around (where N is an integer of 2 or more) in the circumferential direction, and when the flexible board is wound so that the plurality of recesses are overlaid with each other, the wiring formed on an Mth layer (where M is an integer of 1 or more and less than N) from the inside of N layers formed, and the wiring formed on an M+1th layer are overlaid with each other.

A motor coil board according to the present invention is formed by winding the coil board according to the present invention into a cylindrical shape. The first face is arranged on an inner circumferential side, and the second face is arranged on an outer circumferential side.

The motor coil board according to the present invention makes it possible for the wiring on the inner circumferential-side layer and the wiring on the outer circumferential-side layer to be suitably positioned. Winding misalignment therefore does not occur, so there are no longer coils generating ineffective torque. Torque ripple is reduced. When a motor is formed by using the coil board according to the present invention, a motor having stable performance can be obtained.

A motor according to the present invention is formed by arranging the motor coil board according to the present invention on the inside of a cylindrical yoke, and arranging a rotary shaft and a magnet on the inside of the motor coil board.

A spatial magnetic flux distribution approaches a sine wave in the motor according to the present invention. Torque ripple is reduced. A motor having stable performance is obtained.

### [Brief Description of the Drawings]

[Fig. 1] is a plan view schematically showing a coil board according to an embodiment.
[Fig. 2] is a view in cross section schematically showing the coil board according to an embodiment.
[Fig. 3] is an oblique view schematically showing a motor coil board according to an embodiment.
[Fig. 4] is an illustrative diagram in cross section schematically showing a portion of the motor coil board according to an embodiment.
[Fig. 5] is a view in cross section schematically showing a motor according to an embodiment.
[Fig. 6] is a plan view schematically showing a coil board according to a first modified example.
[Fig. 7] is a bottom view schematically showing the coil board according to the first modified example.
[Fig. 8] is an illustrative diagram in cross section schematically showing a portion of the motor coil board according to the first modified example.

### [Embodiment of the Invention]

### [Embodiment]

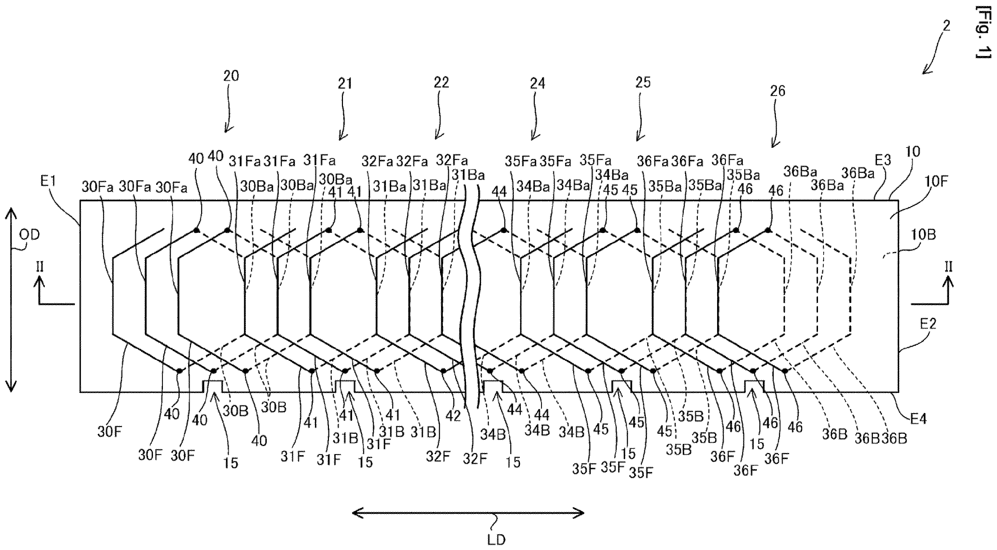

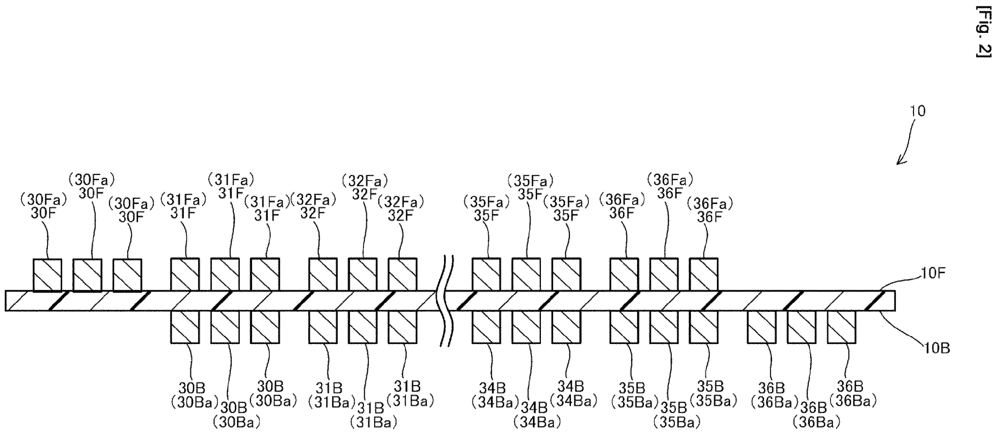

Fig. 1 is a plan view showing a coil board 2 according to an embodiment. Fig. 2 is a view in the cross section II-II in fig. 1. As shown in fig. 1, the coil board 2 comprises a flexible board 10, and a plurality of coils 20, 21, 22, 24, 25, 26. Fig. 1 shows only the coils 20, 21, 22, 24, 25, 26, but the coil board 2 may also comprise coils other than the coils 20, 21, 22, 24, 25, 26.

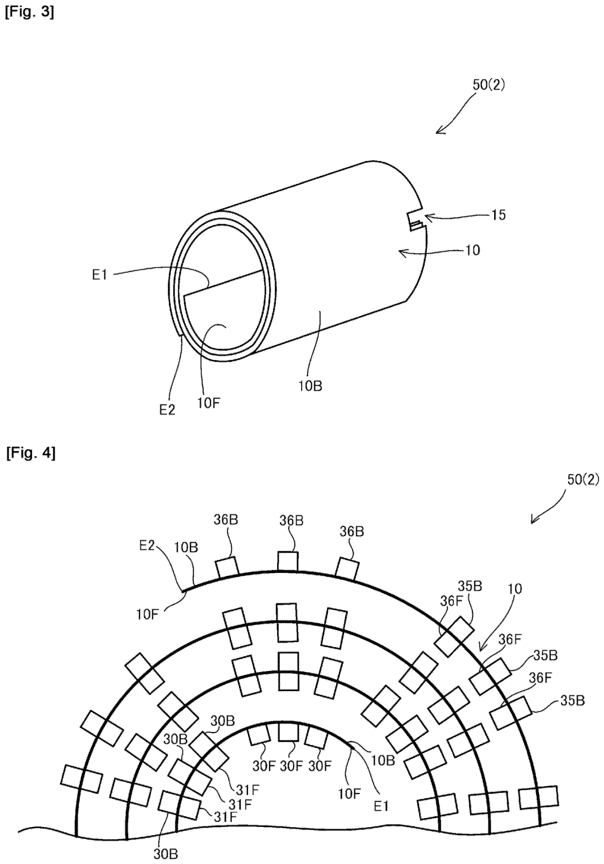

The flexible board 10 is a resin board comprising the first face 10F and the second face 10B on the opposite side to the first face 10F. The flexible board 10 is formed by using an insulating resin such as polyimide or polyamide. The flexible board 10 is capable of flexing. The flexible board 10 is formed in a rectangular shape with four edges, which are a first edge E1 to a fourth edge E4. The first edge E1 is a short edge at one end of the flexible board 10 in a longitudinal direction (direction of the arrow LD in fig. 1). The second edge E2 is a short edge at the other end in the longitudinal direction. The first edge E1 and the second edge E2 are both short edges extending along an orthogonal direction (direction of the arrow OD in fig. 1) which is orthogonal to the longitudinal direction. The third edge E3 and the fourth edge E4 are both long edges extending along the longitudinal direction. A middle part of the flexible board 10 in the longitudinal direction has been omitted from fig. 1 and 2. As will be described in detail later, when the coil board 2 is wound into a cylindrical shape to form the motor coil board 50 (see fig. 3), the first face 10F is arranged on an inner circumferential side and the second face 10B is arranged on an outer circumferential side.

A plurality of recesses 15 are formed along the longitudinal direction on the fourth edge E4 of the flexible board 10. The recesses 15 are formed by cutting away rectangular portions of the fourth edge E4 of the flexible board 10. The parts which are cut away to form the recesses 15 may be parts where leads for electroplating to form the coils are disposed. That is to say, the recesses 15 are formed by cutting away portions of the flexible board 10 in order to remove the leads. The recesses 15 are formed on at least one of the two edges in the width direction of the flexible board 10 (the third edge E3 and the fourth edge E4). The recesses 15 are used for positioning when the coil board 2 is wound in a circumferential direction. Furthermore, the number of times that the coil board is wound is not particularly limited.

The coils 20, 21, 22, 24, 25, 26 are aligned along the longitudinal direction of the flexible board 10. The coils 20, 21, 22 and the coils 24, 25, 26 may respectively constitute a U phase, V phase and W phase of a three-phase motor. The coils 20, 21, 22, 24, 25, 26 are aligned in that order from the first edge E1 toward the second edge E2. Other coils which are not depicted are provided between the coils 20, 21, 22 and the coils 24, 25, 26. The coils are formed by means of first wiring (see the reference symbols 30F, 31F, etc. in fig. 1) provided on the first face 10F, and second wiring (see the reference symbols 30B, 31B, etc.) provided on the second face 10B.

In order to form the coil 20, first wiring 30F constituting a half turn of one turn is formed on the first face 10F side, second wiring 30B constituting a remaining half turn is formed on the second face 10B side, and adjacent turns are arranged offset from each other. In fig. 1, the coil 20 comprises three turns of wiring. The first wiring 30F and the second wiring 30B constituting each turn are electrically connected through via conductors 40 penetrating the flexible board 10. The first wiring 30F has first orthogonal portions 30Fa extending along the orthogonal direction (see the arrow OD). The second wiring 30B also has second orthogonal portions 30Ba extending along the orthogonal direction.

In the same way, in order to form the coil 21, first wiring 31F constituting a half turn of one turn is formed on the first face 10F side, second wiring 31B constituting a remaining half turn is formed on the second face 10B side, and adjacent turns are arranged offset from each other. The coil 21 comprises three turns of wiring. The first wiring 31F and the second wiring 31B constituting each turn are electrically connected through via conductors 41. The first wiring 31F has first orthogonal portions 31Fa extending along the orthogonal direction (see the arrow OD). The second wiring 31B also has second orthogonal portions 31Ba extending along the orthogonal direction.

In the same way, the coil 22 also comprises three turns of first wiring 32F and second wiring (not depicted). The first wiring 32F and the second wiring are connected through via conductors 42. The first wiring 32F has first orthogonal portions 32Fa, and the second wiring has second orthogonal portions.

As shown in fig. 1 and 2, the second orthogonal portions 30Ba of the second wiring 30B constituting the coil 20 overlap, through the flexible board 10, the first orthogonal portions 31Fa of the first wiring 31F constituting the adjacent coil 21. The second orthogonal portions 31Ba of the second wiring 31B constituting the coil 21 overlap, through the flexible board 10, the first orthogonal portions 32Fa of the first wiring 32F constituting the adjacent coil 22.

The coil 24 likewise also comprises three turns of first wiring (not depicted) and second wiring 34B. The first wiring and the second wiring 34B are connected through via conductors 44. The first wiring has first orthogonal portions, and the second wiring 34B has second orthogonal portions 34Ba. The coil 25 also comprises three turns of first wiring 35F and second wiring 35B. The first wiring 35F and the second wiring 35B are connected through via conductors 45. The first wiring 35F has first orthogonal portions 35Fa, and the second wiring 35B has second orthogonal portions 35Ba. The coil 26 also comprises three turns of first wiring 36F and second wiring 36B. The first wiring 36F and the second wiring 36B are connected through via conductors 46. The first wiring 36F has first orthogonal portions 36Fa, and the second wiring 36B has second orthogonal portions 36Ba.

The second orthogonal portions 34Ba of the second wiring 34B constituting the coil 24 overlap, through the flexible board 10, the first orthogonal portions 35Fa of the first wiring 35F constituting the adjacent coil 25. The second orthogonal portions 35Ba of the second wiring 35B constituting the coil 25 overlap, through the flexible board 10, the first orthogonal portions 36Fa of the first wiring 36F constituting the adjacent coil 26.

The arrangement in fig. 1 and 2 is purely an example. In another modified example, the second orthogonal portions 30Ba of the second wiring 30B constituting the coil 20 need not overlap the first orthogonal portions 31 Fa of the first wiring 31F constituting the immediately adjacent coil 21, provided that they overlap the first orthogonal portions of first wiring constituting another coil (e.g., the first orthogonal portions of the first wiring of the coil three along). The same also applies to the coils 21, 22, 24, 25, 26.

The first face 10F and the first wiring 30F, etc. are covered by a resin insulating layer, although this is not shown in the drawings. The second face 10B and the second wiring 30B, etc. are likewise covered by a resin insulating layer.

Fig. 3 is an oblique view schematically showing a motor coil board 50 employing the coil board 2 (fig. 1 and 2) of the embodiment. As shown in fig. 3, the motor coil board 50 for a motor is formed by winding the coil board 2 (fig. 1 and 2) of the embodiment into a cylindrical shape. When wound into a cylindrical shape, the coil board 2 is wound N times around (where N is an integer of 2 or more) in the circumferential direction about an axis extending in the orthogonal direction (an axis extending parallel to the first edge E1 (see fig. 1)), starting from the first edge E1. The coil 2 is wound four times around in the example of fig. 3. The first face 10F of the flexible board 10 is arranged on the inner circumferential side, and the second face 10B is arranged on the outer circumferential side when the coil board 2 is wound into a cylindrical shape. As shown in fig. 3, in this embodiment, the plurality of recesses 15 formed on the flexible board 10 are overlaid with each other by winding the flexible board 10 in the circumferential direction.

Fig. 4 is an illustrative diagram in cross section schematically showing a portion of the motor coil board 50 in fig. 3. As shown in the drawing, four layers are formed by winding the flexible board 10 of the motor coil board 50. The motor coil board 50 comprises, in succession from the innermost circumference, a first layer, a second layer, a third layer, and a fourth layer. The part of the flexible board 10 in the vicinity of the first edge E1, which is the starting end for winding, forms the innermost first layer, and the part in the vicinity of the second edge E2, which is the terminal end, forms the outermost fourth layer.

The plurality of recesses 15 are overlaid with each other when the coil board 2 is wound into a cylindrical shape. As a result, the wiring formed on an Mth layer (where M is an integer of 1 or more and less than N) from the inside of N layers formed, and the wiring formed on an M+1th layer are overlaid with each other. In the example of fig. 4, the wiring formed on the first layer and the wiring formed on the second layer are overlaid with each other. The wiring formed on the second layer and the wiring formed on the third layer are overlaid with each other. The wiring formed on the third layer and the wiring formed on the fourth layer are overlaid with each other. That is to say, the plurality of recesses 15 (fig. 1 and 3) are used for positioning in order to wind the coil board 2 so that the wiring on the Mth layer and the wiring on the M+1th layer are overlaid with each other. Furthermore, the number of times that the coil board is wound is not particularly limited.

In the embodiment, when the coil board 2 is wound so that the plurality of recesses 15 are overlaid with each other, the width and spacing, etc. of the wiring forming the coils 20, 21, 22, 24, 25, 26, etc. which are formed on the coil board 2 are adjusted so that the wiring on the Mth layer and the wiring on the M+1th layer are overlaid with each other. In the motor coil board 50 formed by winding the coil board 2 in the circumferential direction, the first face 10F is arranged on the inner circumferential side, and the second face 10B is arranged on the outer circumferential side.

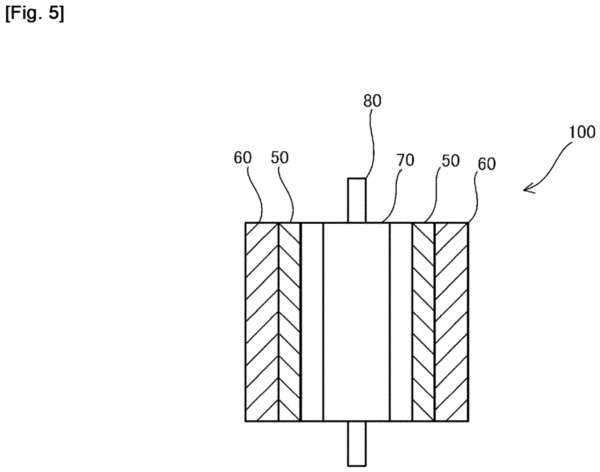

Fig. 5 is a view in cross section schematically showing a motor 100 employing the motor coil board 50 (fig. 3 and 4) of the embodiment. The motor 100 is formed by arranging the motor coil board 50 on the inside of a yoke 60, and arranging a rotary shaft 80 and a magnet 70, which is fixed to the rotary shaft 80, on the inside of the motor coil board 50.

The configurations of the coil board 2 (fig. 1 and 2), the motor coil board 50 (fig. 3 and 4), and the motor 100 (fig. 5) of the embodiment are as described above. By using the recesses 15 as a reference for positioning when the motor coil board 50 is formed by using the coil board 2 of this embodiment, the wiring on the inner circumferential-side layer and the wiring on the outer circumferential-side layer are suitably positioned when the cylindrical shape has been formed. A spatial magnetic flux distribution therefore approaches a sine wave in the motor coil board 50. Torque ripple is reduced. When the motor 100 is formed by using the coil board 2 of the embodiment, a motor 100 having stable performance can therefore be obtained.

### [Different example of the embodiment]

In a different example of the embodiment, the recesses 15 are formed on both the third edge E3 and the fourth edge E4 of the flexible board 10.

### [First modified example of the embodiment]

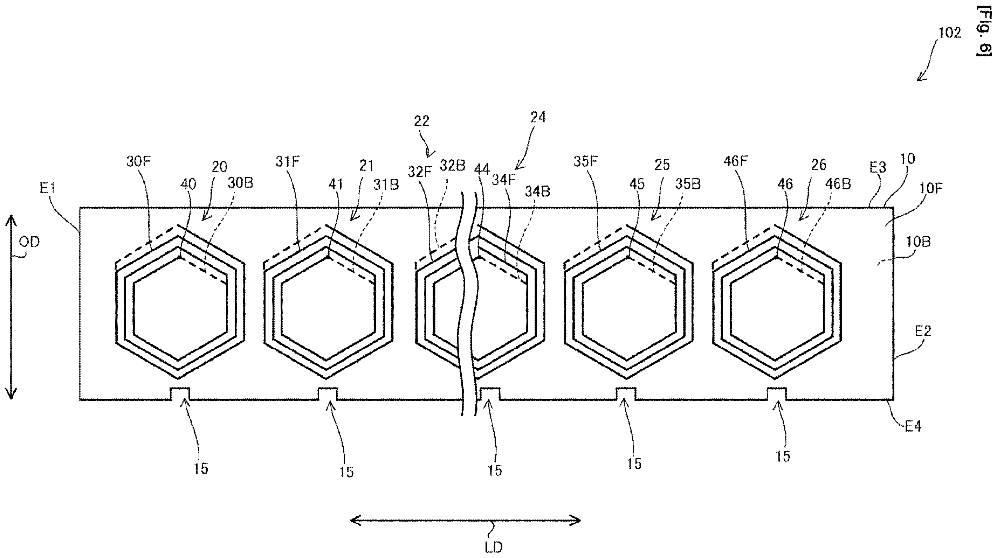

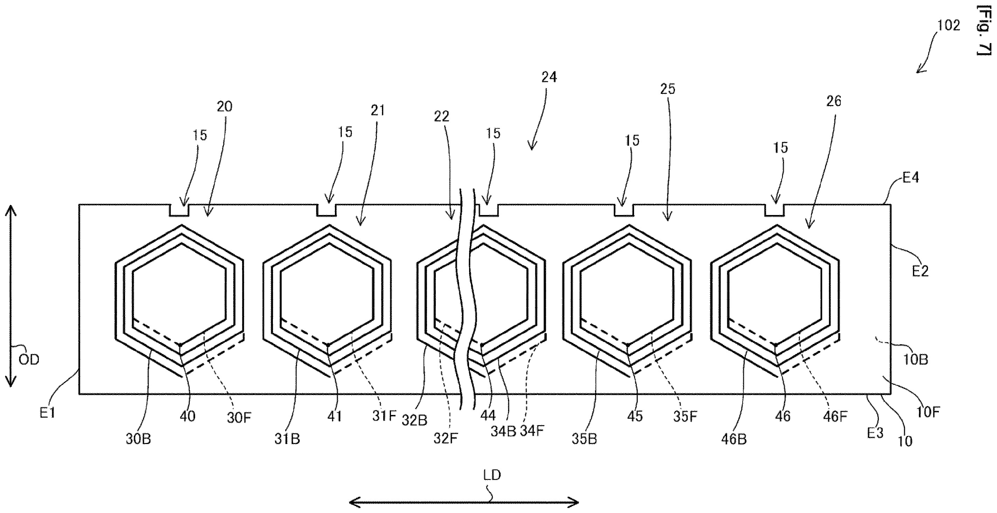

Fig. 6-8 show a first modified example of the embodiment. In the first modified example, the arrangement of the wiring constituting the coils 20, 21, 22, 24, 25, 26, etc. differs from that of the embodiment. Fig. 6 is a plan view showing a coil board 102 according to the first modified example. Fig. 7 is a bottom view showing the coil board 102 according to the first modified example.

The coil 20 comprises coil-shaped first wiring 30F (fig. 6) provided on the first face 10F, and coil-shaped second wiring 30B (fig. 7) provided on the second face 10B. The first wiring 30F and the second wiring 30B are electrically connected through a via conductor 40 penetrating the flexible board 10. The coil 21 likewise comprises first wiring 31F, second wiring 31B, and a via conductor 41. The coil 22 comprises first wiring 32F, second wiring 32B, and a via conductor 42. The coil 24 comprises first wiring 34F, second wiring 34B, and a via conductor 44. The coil 25 comprises first wiring 35F, second wiring 35B, and a via conductor 45. The coil 26 comprises first wiring 36F, second wiring 36B, and a via conductor 46.

As shown in fig. 6, the first wiring 30F is formed in a spiral shape (hexagonal spiral shape) winding clockwise from the outer circumference toward the inner circumference. The via conductor 40 is formed at an inner circumferential end of the first wiring 30F. As shown in fig. 7, the second wiring 30B is formed in a spiral shape (hexagonal spiral shape) winding counterclockwise from the inner circumference toward the outer circumference. The via conductor 40 is formed at an inner circumferential end of the second wiring 30B. The first wiring 30F and the second wiring 30B are formed in a spiral shape with the same winding direction as seen from the same face. The first wiring 30F and the second wiring 30B function as a single coil 20 in which they are electrically connected in series.

The first wiring 31F (32F, 34F, 35F, 36F) and the second wiring 31B (32B, 34B, 35B, 36B) have the same relationship as the first wiring 30F and the second wiring 30B. The first wiring 31F (32F, 34F, 35F, 36F) and the second wiring 31B (32B, 34B, 35B, 36B) function as a single coil 21 (22, 24, 25, 26) in which they are electrically connected in series.

A plurality of recesses 15 are formed along the longitudinal direction on the fourth edge E4 of the flexible board 10 in the first modified example also. Furthermore, the first face 10F and the first wiring 30F-32F, 34F-36F are covered over by a resin insulating layer, although this is not shown in the drawings. The second face 10B and the second wiring 30B-32B, 34B-36B are likewise covered over by a resin insulating layer.

The motor coil board 50 (see fig. 3) for a motor is formed by winding the coil board 2 (fig. 6 and 7) of the first modified example into a cylindrical shape. The plurality of recesses 15 formed on the flexible board 10 are overlaid with each other by winding the flexible board 10 in the circumferential direction.

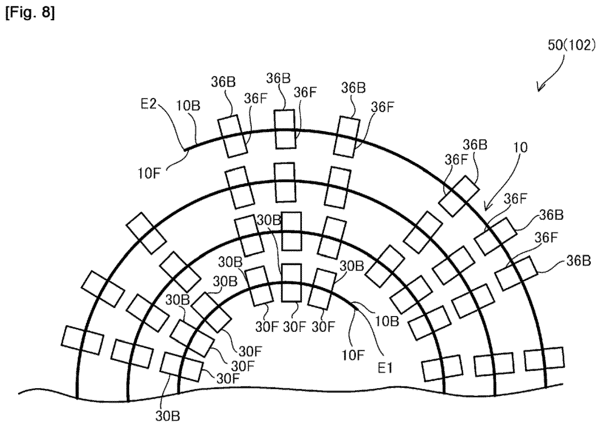

Fig. 8 is an illustrative diagram in cross section schematically showing a portion of the motor coil board 50 according to the first modified example. The wiring formed on an Mth layer (where M is an integer of 1 or more and less than N) from the inside of N layers (four layers in the example depicted) formed, and the wiring formed on an M+1th layer are overlaid with each other. The plurality of recesses 15 (fig. 6 and 7) are used for positioning in order to wind the coil board 2 so that the wiring on the Mth layer and the wiring on the M+1th layer are overlaid with each other.

### [Different example of the first modified example]

In a different example of the first modified example, the recesses 15 are formed on both the third edge E3 and the fourth edge E4 of the flexible board 10.

### [Key to Symbols]

2: Coil board
10: Flexible board
10F: First face
10B: Second face
15: Recess
20, 21, 22, 24, 25, 26: Coil
30F, 31F, 32F, 34F, 35F, 36F: First wiring
30Fa, 31Fa, 32Fa, 34Fa, 35Fa, 36Fa: First orthogonal portion
30B, 31B, 32B, 34B, 35B, 36B: Second wiring
30Ba, 31Ba, 32Ba, 34Ba, 35Ba, 36Ba: Second orthogonal portion
50: Motor coil board
60: Yoke
70: Magnet
80: Rotary shaft
100: Motor

## Claims

1. A coil board comprising: a flexible board having a first face and a second face on the opposite side to the first face; and
coils formed by coil-shaped wiring provided on the first face and coil-shaped wiring provided on the second face, wherein
the coil board is wound in a circumferential direction about an axis extending in a width direction orthogonal to a longitudinal direction of the flexible board, starting from a reference edge on one end side of the flexible board in the longitudinal direction, and can thereby be formed into a cylindrical shape, and
the flexible board comprises a recess formed on at least one of two edges in the width direction.

2. The coil board of claim 1, wherein the recess is used for positioning when the coil board is wound in the circumferential direction.

3. The coil board of claim 1, wherein the flexible board comprises a plurality of the recesses formed along the longitudinal direction on at least one of the two edges in the width direction.

4. The coil board of claim 3, wherein the plurality of recesses are overlaid with each other by winding the flexible board N times around (where N is an integer of 2 or more) in the circumferential direction, and when the flexible board is wound so that the plurality of recesses are overlaid with each other, the wiring formed on an Mth layer (where M is an integer of 1 or more and less than N) from the inside of N layers formed, and the wiring formed on an M+1th layer are overlaid with each other.

5. A motor coil board formed by winding the coil board of claim 1 in a circumferential direction, wherein the first face is arranged on an inner circumferential side, and the second face is arranged on an outer circumferential side.

6. A motor which is formed by arranging the motor coil board of claim 5 on the inside of a cylindrical yoke, and arranging a rotary shaft and a magnet on the inside of the motor coil board.
